# EUROPEAN PATENT APPLICATION

(11) **EP 4 546 420 A1**
(43) Date of publication of application: **30.04.2025**
(21) Application number: 24196789.2
(22) Date of filing: 27.08.2024
(51) Int. Cl.: H01L 23/538, H01L 23/00, H01L 25/065

(54) **HIGH PERFORMANCE MICROELECTRONIC ASSEMBLIES INCLUDING THROUGH-SILICON VIA BRIDGES WITH TOP DIE FIRST APPROACH**

(30) Priority: 27.09.2023 US 202318475373
(71) Applicant: INTEL Corporation, Santa Clara, CA 95054 (US)
(72) Inventor: DUAN, Gang, Chandler, AZ 85248 (US); KANAOKA, Yosuke, Chandler, AZ 85249 (US); LIU, Minglu, Chandler, AZ 85248 (US); PIETAMBARAM, Srinivas V., Chandler, AZ 85249 (US); MARIN, Brandon C., Gilbert, AZ 85234 (US); SHAN, Bohan, Chandler, AZ 85226 (US); CHEN, Haobo, Chandler, AZ 85249 (US); ECTON, Jeremy, Gilbert, AZ 85298 (US); DUONG, Benjamin T., Phoenix, AZ 85044 (US); NAD, Suddhasattwa, Chandler, AZ 85249 (US)
(74) Representative: 2SPL Patentanwälte PartG mbB

(57) **Abstract**

Microelectronic assemblies, related devices and methods, are disclosed herein. In some embodiments, a microelectronic assembly may include a first layer having first dies in a first insulating material; a second layer on the first layer, the second layer including second dies having a first thickness and third dies having a second thickness different than the first thickness, the second dies and the third dies in a second insulating material, wherein the second dies and third dies have a first surface and an opposing second surface, and wherein the first surfaces of the second and third dies have a combined surface area between 3,000 square millimeters (mm²) and 9,000 mm²; and a redistribution layer (RDL) between the first layer and the second layer, the RDL including conductive pathways, wherein the first dies are electrically coupled to the second dies and the third dies by the conductive pathways and by interconnects.

## Description

### Background

Integrated circuit (IC) devices (e.g., dies) are typically coupled together in a multi-die IC package to integrate features or functionality and to facilitate connections to other components, such as package substrates.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a side, cross-sectional view of an example microelectronic assembly, in accordance with various embodiments.
FIGS. 2A-2F are top views of example microelectronic assemblies, in accordance with various embodiments.
FIGS. 3A-3C are side, cross-sectional views of other example microelectronic assemblies, in accordance with various embodiments.
FIG. 3D is a schematic cross-sectional view of a portion of the example microelectronic assembly of FIG. 3C.
FIGS. 4A-4I are side, cross-sectional views of various stages in an example process for manufacturing a microelectronic assembly, in accordance with various embodiments.
FIGS. 5A-5H are side, cross-sectional views of various stages in an example process for manufacturing a microelectronic assembly, in accordance with various embodiments.
FIG. 6 is a flow diagram of an example method of fabricating an example microelectronic assembly, in accordance with various embodiments.
FIG. 7 is a flow diagram of another example method of fabricating an example microelectronic assembly, in accordance with various embodiments.
FIG. 8 is a cross-sectional view of a device package that includes one or more microelectronic assemblies in accordance with any of the embodiments disclosed herein.
FIG. 9 is a cross-sectional side view of a device assembly that includes one or more microelectronic assemblies in accordance with any of the embodiments disclosed herein.
FIG. 10 is a block diagram of an example computing device that includes one or more microelectronic assemblies in accordance with any of the embodiments disclosed herein.

### Detailed Description

### Overview

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in any way to limit the broad scope of the present disclosure and its potential applications.

As demands for high performance computing (HPC) continue to rise, heterogeneous integration has become an important performance enabler. The focus to enable heterogeneous integration scaling is to push interconnect density with increased bandwidth and improved power efficiency. Many different advanced packaging architectures have been deployed to increase planar and 3-dimensional (3D) input/output (I/O) wire per area density for higher data bandwidth requirements, and to enable more effective die disaggregation and heterogeneous integration to shorten the time to market. More recently, industry has moved quickly into 2.5D/3D advanced packaging technologies, such as die embedding and/or silicon interposer to enable significantly higher package I/O counts and density to meet the HPC segment market demands and product performance needs.

At the same time, system level heterogeneous integration has been attracting significant interest due to its extremely high potential in supercomputing, autonomous driving, and machine learning applications. Extremely high-performance computing drives significant packaging innovations and disruptive system level architectures. Such high performance computing demand drives very large form factor package and system level heterogenous integration of compute tiles, I/O, memory, power delivery, and thermal cooling solutions. The microelectronic assemblies disclosed herein may achieve very large form factor structures having increased interconnect densities, reduced routing distances, and improved signal and power integrity compared to conventional approaches, without costly manufacturing operations. Further, the microelectronic structures and assemblies disclosed herein offer new flexibility to electronics designers and manufacturers, allowing them to select an architecture that achieves their device goals without excess cost or manufacturing complexity.

Accordingly, microelectronic assemblies, related devices and methods, are disclosed herein. For example, in some embodiments, a microelectronic assembly may include a first layer having first dies in a first insulating material; a second layer on the first layer, the second layer including second dies having a first thickness and third dies having a second thickness different than the first thickness, the second dies and the third dies in a second insulating material, wherein the second dies and third dies have a first surface and an opposing second surface, and wherein the first surfaces of the second and third dies have a combined surface area between 3,000 square millimeters (mm²) and 9,000 mm²; and a redistribution layer (RDL) between the first layer and the second layer, the RDL including conductive pathways, wherein the first dies are electrically coupled to the second dies and the third dies by the conductive pathways and by interconnects.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may include substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

In another example, the terms "package" and "IC package" are synonymous, as are the terms "die" and "IC die." Note that the terms "chip," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may include a semiconductor material, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may include a non-crystalline material, such as polymers. In some embodiments, the PIC may be formed on a printed circuit board (PCB). In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiOj, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material includes interlayer low-k dielectric that is provided within the IC die. Within package substrates, and PCBs such insulating material includes organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

In context of a stack of dies coupled to one another or in context of a die coupled to a package substate, the term "interconnect" may also refer to, respectively, die-to-die (DTD) interconnects and die-to-package substrate (DTPS) interconnects. DTD interconnects may also be referred to as first-level interconnects (FLI). DTPS interconnects may also be referred to as Second-Level Interconnects (SLI). Although not specifically shown in all of the present illustrations in order to not clutter the drawings, when DTD or DTPS interconnects are described, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the DTD or DTPS interconnects. In some embodiments, the pitch of the DTD interconnects may be different from the pitch of the DTPS interconnects, although, in other embodiments, these pitches may be substantially the same.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may include the same or different insulating materials. In some embodiments, the levels of underfill may include thermoset epoxies with silicon oxide particles; in some embodiments, the levels of underfill may include any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

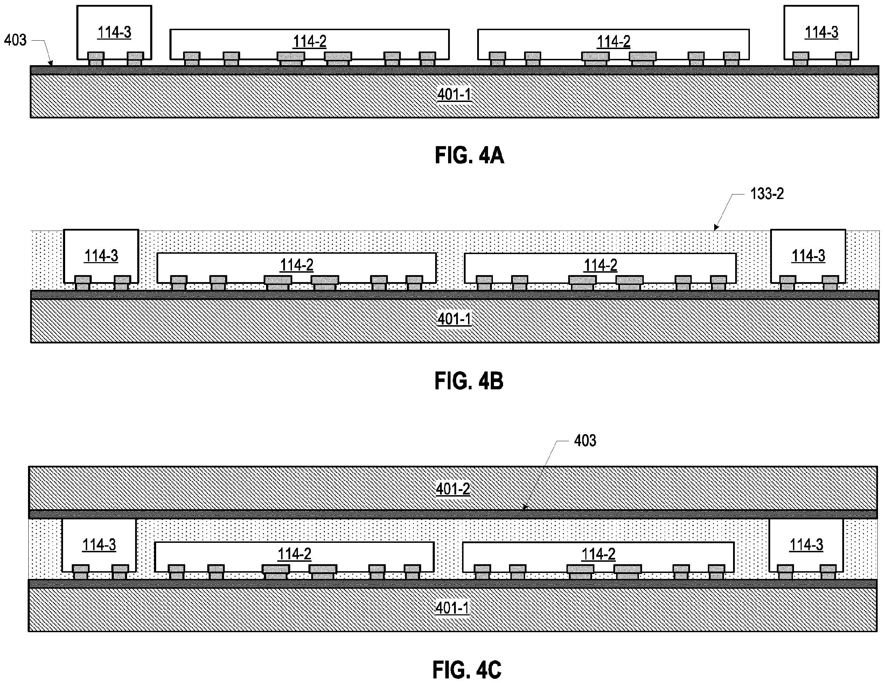

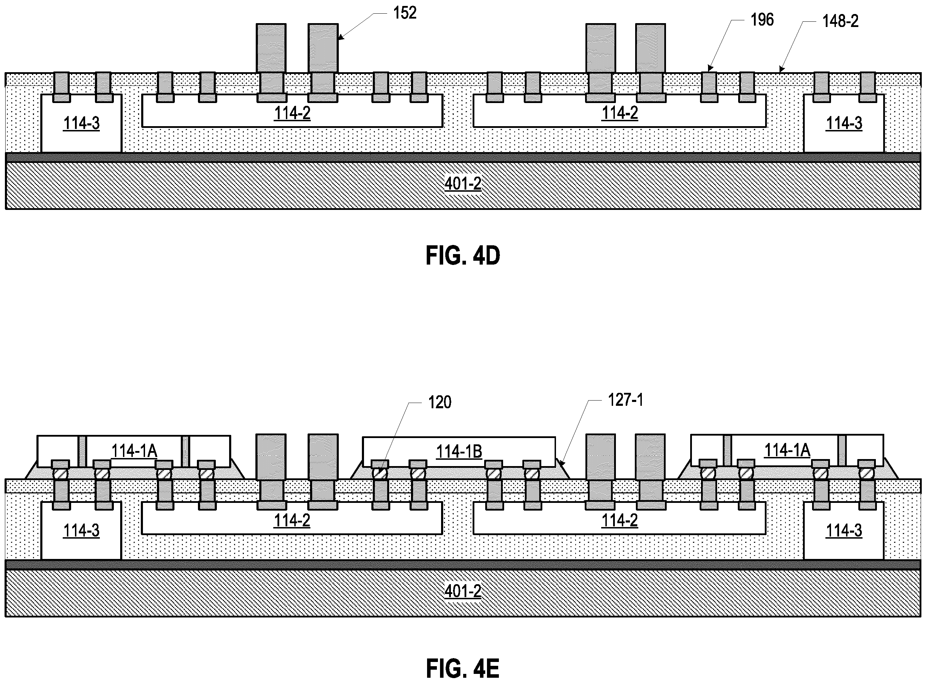

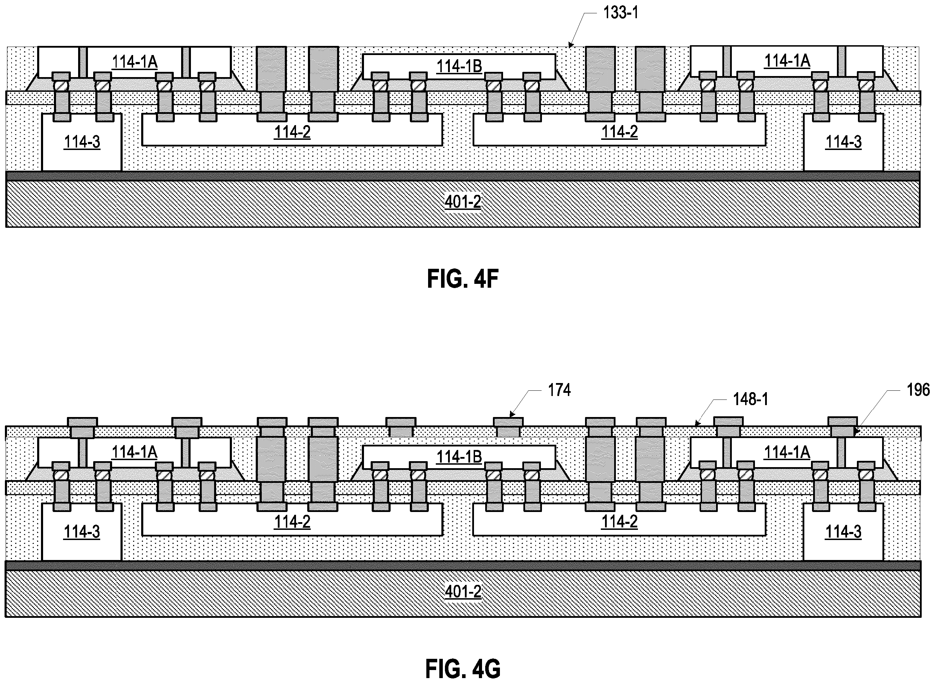

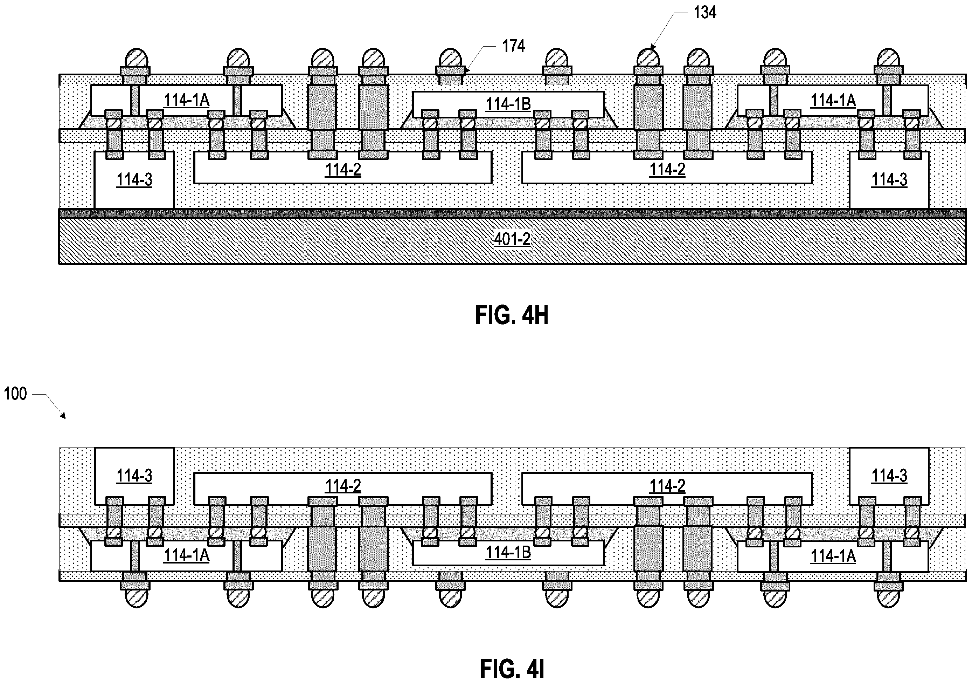

For convenience, if a collection of drawings designated with different letters are present (e.g., FIGS. 4A-4I), such a collection may be referred to herein without the letters (e.g., as "FIG. 4"). Similarly, if a collection of reference numerals designated with different numbers are present (e.g., 148-1, 148-2), such a collection may be referred to herein without the numbers (e.g., as "148").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

### Example embodiments

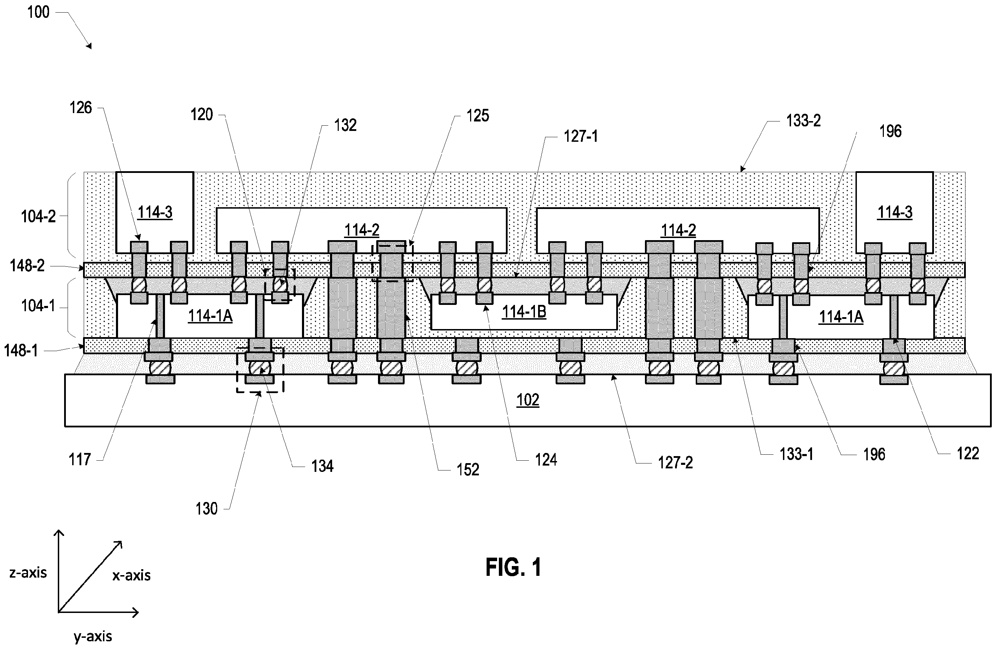

FIG. 1 is a side, cross-sectional view of an example microelectronic assembly, in accordance with various embodiments. The microelectronic assembly 100 may include multiple layers 104 of dies 114 coupled by RDLs 148. In particular, a microelectronic assembly 100 may include a first layer 104-1 of first layer dies 114-1 and conductive pillars 152 with a first RDL 148-1 at a bottom surface and a second RDL 148-2 at a top surface, and a second layer 104-2 of second layer dies 114-2, 114-3 on the second RDL 148-2. The first layer dies 114-1 may include double-sided dies 114-1A and single-sided dies 114-1B. The double-sided first layer die 114-1A may include a bottom surface and a top surface with conductive contacts and through-silicon vias (TSVs) 117. The single-sided first layer die 114-1B may include a top surface with conductive contacts. In this context, a double-sided die refers to a die that has connections on both surfaces. The active surface of a double-sided die, which is the surface containing one or more active devices and a majority of interconnects, may face either direction depending on the design and electrical requirements. The first layer dies 114-1 (e.g., first layer dies 114-1A and 114-1B) may include conductive contacts 124 at a top surface. The first layer dies 114-1A may further include conductive contacts 122 at a bottom surface and TSVs 117. The conductive contacts 122, 124 may have a single pitch or may have a mixed pitch. The second layer dies 114-2, 114-3 may include conductive contacts 126 on the bottom surface. The conductive contacts 126 may have a single pitch or may have a mixed pitch. In some embodiments, the second layer dies 114-2, 114-3 may include double-sided dies, for example, to electrically couple to third layer dies (not shown). The second layer dies 114-2, 114-3 may include dies having a single pitch (e.g., as shown for dies 114-3) and/or dies having a mixed pitch (e.g., as shown for dies 114-2). In some embodiments, the first layer dies 114-1 may include an active/passive bridge die (e.g., with or without metal-insulator-metal (MIM) capacitors) for enabling communications between second layer die 114-2 and 114-3. In some embodiments, the second layer die 114-2 may include a central processing unit (CPU)), a graphics processing die (GPU), a system-on-chip die (SOC), an input/output (I/O) die, or other similar dies, and the second layer die 114-3 may include a high bandwidth memory (HBM) die. In some embodiments, the first layer dies 114-1 may have different thicknesses (e.g., a first layer die 114-1A may have a greater thickness than a first layer die 114-1B, as shown). In some embodiments, the second layer dies 114-2, 114-3 may have different thicknesses (e.g., a second layer die 114-3 may have a greater thickness than a second layer die 114-2, as shown).

The first and second RDLs 148-1, 148-2 may include conductive pathways 196 through a dielectric material. The first layer dies 114-1 may be electrically coupled to the second layer dies 114-2, 114-3 by the conductive pathways 196 through the second RDL 148-1 and by interconnects 120. Interconnects 120 also may be referred to herein as DTD interconnects. Interconnects 120 may have a single pitch or may have a mixed pitch. In some embodiments, interconnects 120 may have a pitch between 1 micron and 75 microns (e.g., between 1 micron and 10 microns, between 10 microns and 25 microns, or between 25 microns and 75 microns). In some embodiments, interconnects 120 may include solder 132 (e.g., solder bumps or balls that are subject to a thermal reflow to form the interconnects 120, as shown). In such embodiments, the microelectronic assembly 100 may further include an underfill material 127-1 between the top surface of the first layer dies 114-1 and the second RDL 148-1 around interconnects 120. The underfill material 127-1 may have an inverted trapezoidal shape (e.g., a trapezoid having a smaller length (i.e., y-dimension) adjacent to the top surface of the first layer die 114-1 and a greater length away from the top surface of the first layer die 114-1 (e.g., towards the second RDL 148-2)).

The first layer dies 114-1A may be electrically coupled to a package substrate 102 by conductive pathways 196 through the first RDL 148-1 and by interconnects 130. The second layer die 114-2 may be electrically coupled to the package substrate 102 by conductive pathways through the first and second RDLs 148-1, 148-2, conductive pillars 152 in the first layer, and by interconnects 130. Interconnects 130 also may be referred to herein as DTPS interconnects. In some embodiments, the interconnects 130 disclosed herein may have a pitch between 50 microns and 350 microns. In some embodiments, interconnects 130 may include solder 134 and an underfill material 127-2 may be between the bottom surface of the first RDL 148-1 and a top surface of the package substrate 102 around interconnects 130.

The underfill material 127 may be an insulating material, such as an appropriate epoxy material. In some embodiments, the underfill material 127 may include a capillary underfill, nonconductive film (NCF), or molded underfill. In some embodiments, the underfill material 127 may include an epoxy flux that assists with soldering when forming the interconnects 120, 130, and then polymerizes and encapsulates the interconnects 120, 130. The underfill material 127 may be selected to have a coefficient of thermal expansion (CTE) that may mitigate or minimize the stress between the dies 114, the RDLs 148, and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the dies 114 and/or insulating material of the RDL 148.

The interconnects 120 may have a finer pitch than the interconnects 130. In some embodiments, the interconnects 120 may include solder interconnects with a solder having a higher melting point than solder included in the interconnects 130. For example, when the interconnects 120 are formed before the interconnects 130 are formed, the interconnects 120 may use a higher-temperature solder (e.g., with a melting point above 200 degrees Celsius), while the interconnects 130 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

As used herein, a "conductive contact" may refer to a portion of conductive material (e.g., metal) serving as an electrical interface between different components (e.g., part of a conductive interconnect); conductive contacts may be recessed in, flush with, or extending away from a surface of a component (e.g., as shown in FIG. 1), and may take any suitable form (e.g., a conductive pad or socket, or portion of a conductive line or via). Any of the conductive contacts disclosed herein may include bond pads, solder bumps, conductive posts, or any other suitable conductive contact, for example. As shown in FIG. 1, the second layer dies 114-2, 114-3 are depicted as having conductive contacts extending away from a surface of the dies, and may be referred to herein as "a bumped die" or "a micro-bumped die," and the first layer dies 114-1 are depicted as having conductive contacts flush with a surface of the die and may be referred to herein as "a bumpless die." The die 114 may include other conductive pathways (e.g., including lines and vias) and/or to other circuitry (not shown) coupled to the respective conductive contacts on the surface of the die 114.

The microelectronic assembly 100 may further include a first insulating material 133-1 around the first layer dies 114-1 and conductive pillars 152, and a second insulating material 133-2 around the second layer dies 114-2, 114-3. In some embodiments, the insulating material 133 may include a mold material, such as an organic polymer with inorganic silicon oxide, a resin material, or an epoxy material. In some embodiments, the insulating material 133 may include a mold material, a resin material, or an epoxy material, and may further include a thermally conductive material (e.g., metal particles), such as silver and oxygen (e.g., in the form of silver oxide particles) or aluminum and oxygen (e.g., in the form of aluminum oxide particles), or combinations thereof. In some embodiments, the first insulating material 133-1 and the second insulting material 133-2 are a same material. In some embodiments, the first insulating material 133-1 and the second insulting material 133-2 are different materials.

An RDL 148 may include an insulating material (e.g., a dielectric material formed in multiple layers, as known in the art) and one or more conductive pathways 196 through the dielectric material (e.g., including conductive vias, as shown, or including conductive traces and/or conductive vias). In some embodiments, the RDL 148 may include multiple layers having a conductive fanout structure. In some embodiments, the insulating material of the RDL 148 may be composed of dielectric materials, bismaleimide triazine (BT) resin, polyimide materials, epoxy materials (e.g., glass reinforced epoxy matrix materials, epoxy build-up films, or the like), mold materials, oxide-based materials (e.g., silicon dioxide or spin on oxide), or low-k and ultra low-k dielectric (e.g., carbon-doped dielectrics, fluorine-doped dielectrics, porous dielectrics, and organic polymeric dielectrics). The RDL 148 may have any suitable thickness, for example, in some embodiments, the RDL 148 may have a thickness between 1 micron and 35 microns.

The conductive pillars 152 may be formed of any suitable conductive material, such as copper, silver, nickel, gold, aluminum, or other metals or alloys, for example. The conductive pillars 152 may be formed using any suitable process, including, for example, a lithographic process or an additive process, such as cold spray or 3-dimensional printing. In some embodiments, the conductive pillars 152 disclosed herein may have a pitch between 50 microns and 150 microns. As used herein, pitch is measured center-to-center (e.g., from a center of a conductive pillar to a center of an adjacent conductive pillar). The conductive pillars 152 may have any suitable size and shape. In some embodiments, the conductive pillars 152 may have a circular, rectangular, or other shaped cross-section. The second layer dies 114-2 may be electrically coupled to the conductive pathways 196 in the RDL 148 and to the conductive pillars 152 in the first layer by metal-to-metal interconnects 125 (e.g., copper-to-copper interconnects or plated interconnects).

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked). In some embodiments, the die 114 may include conductive pathways to route power, ground, and/or signals to/from other dies 114 included in the microelectronic assembly 100. For example, the first layer dies 114-1 may include TSVs 117 (e.g., as shown in die 114-1A) or other conductive pathways through which power, ground, and/or signals may be transmitted between the package substrate 102 and the second layer dies 114-2, 114-3. In some embodiments, the second layer dies 114-2 may couple directly to power and/or ground lines in the package substrate 102 by conductive pillars 152.

The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire retardant grade 4 material (FR-4), BT resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 102 is formed using standard printed circuit board (PCB) processes, the package substrate 102 may include FR-4, and the conductive pathways in the package substrate 102 may be formed by patterned sheets of copper separated by build-up layers of the FR-4. The conductive pathways in the package substrate 102 may be bordered by liner materials, such as adhesion liners and/or barrier liners, as suitable. In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material, and creating conductive vias and lines by laser drilling and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the die 114 may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual damascene process. In some embodiments, additional dies may be disposed on the top surface of the second layer dies 114-2, 114-3. In some embodiments, additional components may be disposed on the top surface of the second layer dies 114-2, 114-3. Additional passive components, such as surface-mount resistors, capacitors, and/or inductors, may be disposed on the top surface or the bottom surface of the package substrate 102, or embedded in the package substrate 102.

The microelectronic assembly 100 of FIG. 1 may also include a circuit board (not shown). The package substrate 102 may be coupled to the circuit board by interconnects at the bottom surface of the package substrate 102. The interconnects may include solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the package substrate 102 may not be coupled to a circuit board, but instead may couple the package substrate 102 to another IC package, an interposer, or any other suitable component. In some embodiments, the microelectronic assembly 100 may not include a package substrate 102 but instead the layers of dies through the first RDL 148-1 may be electrically coupled to a circuit board.

Although FIG. 1 depicts a microelectronic assembly 100 having a particular number of layers 104 of dies 114 and RDLs 148, this number and arrangement are simply illustrative, and a microelectronic assembly 100 may include any desired number and arrangement of dies 114 and RDLS 148.

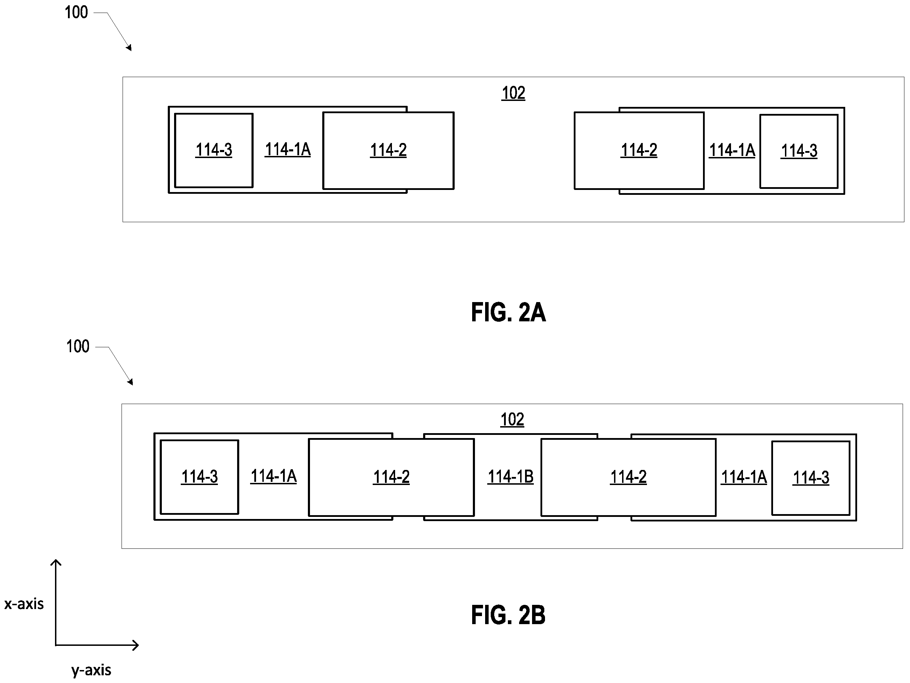

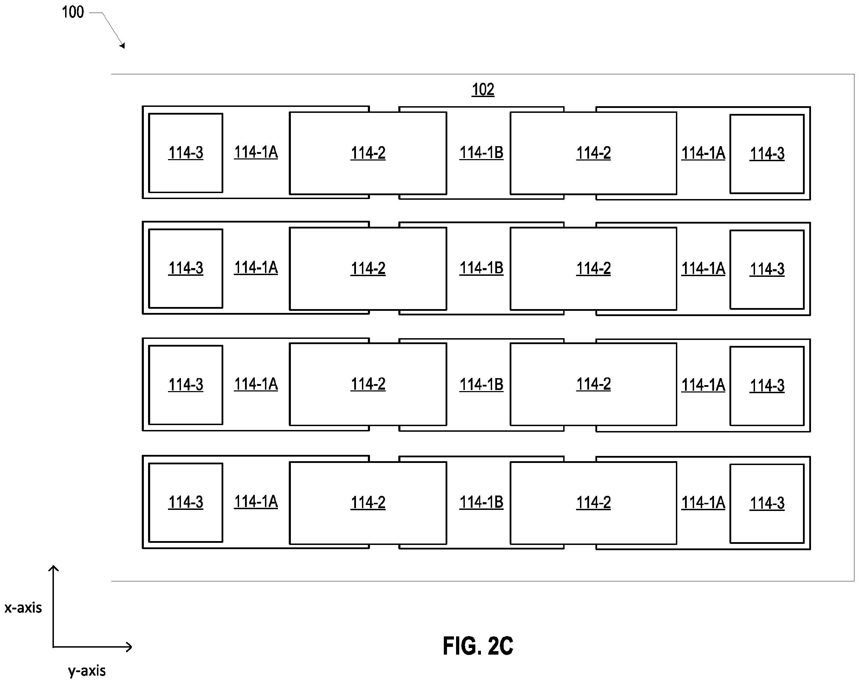

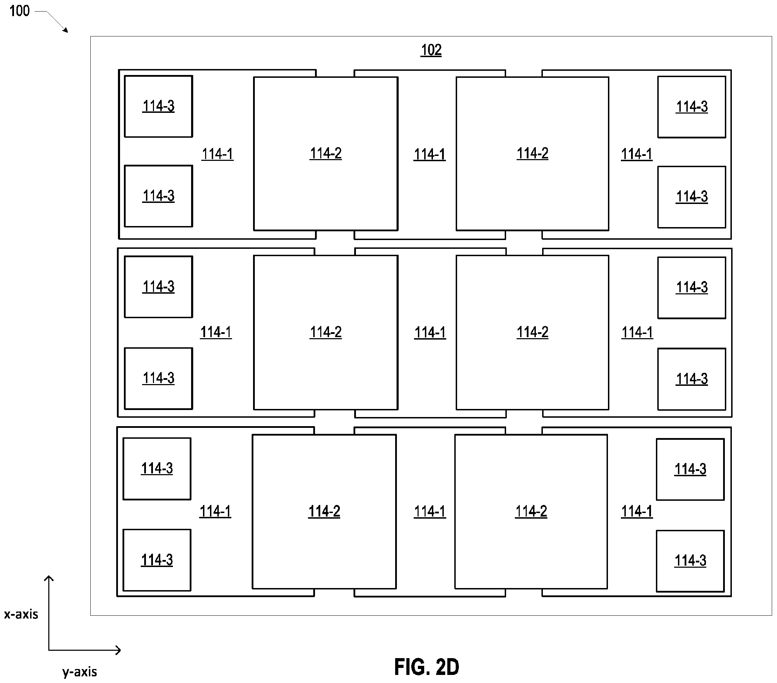

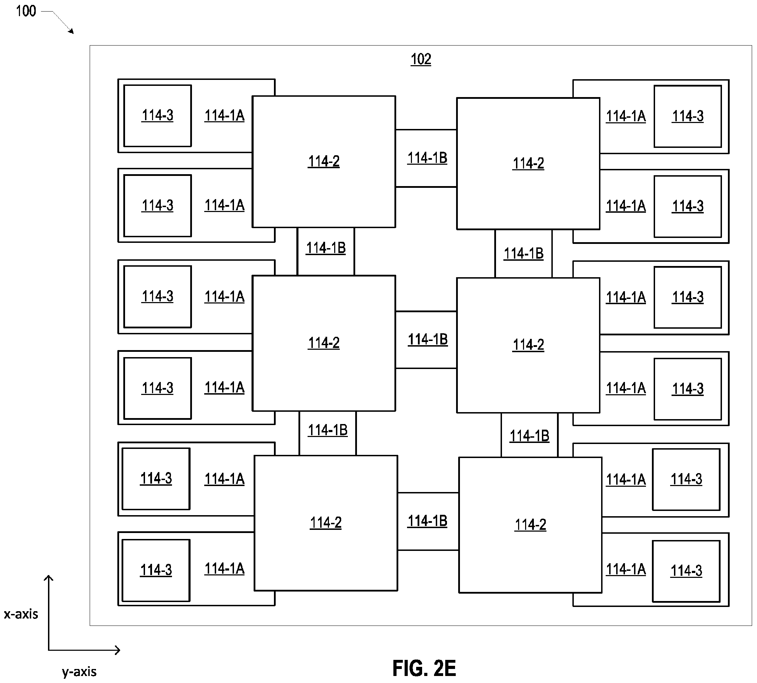

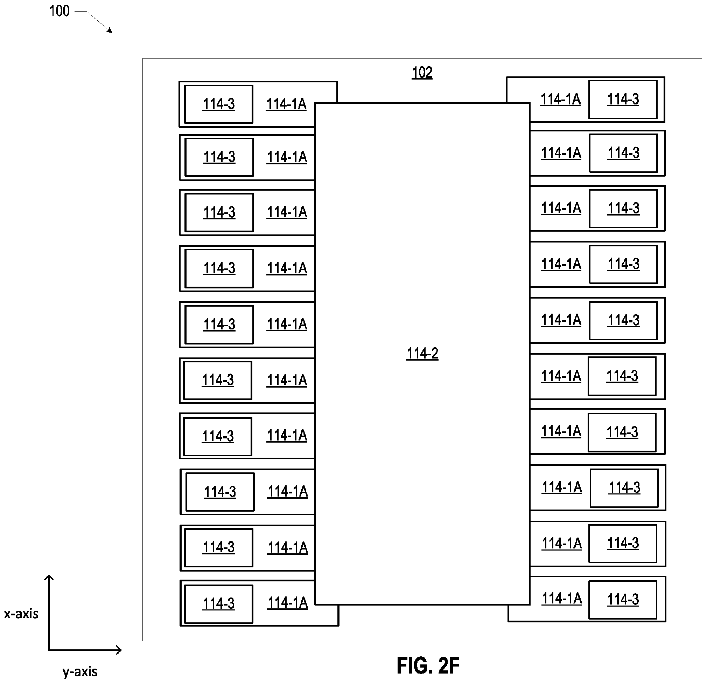

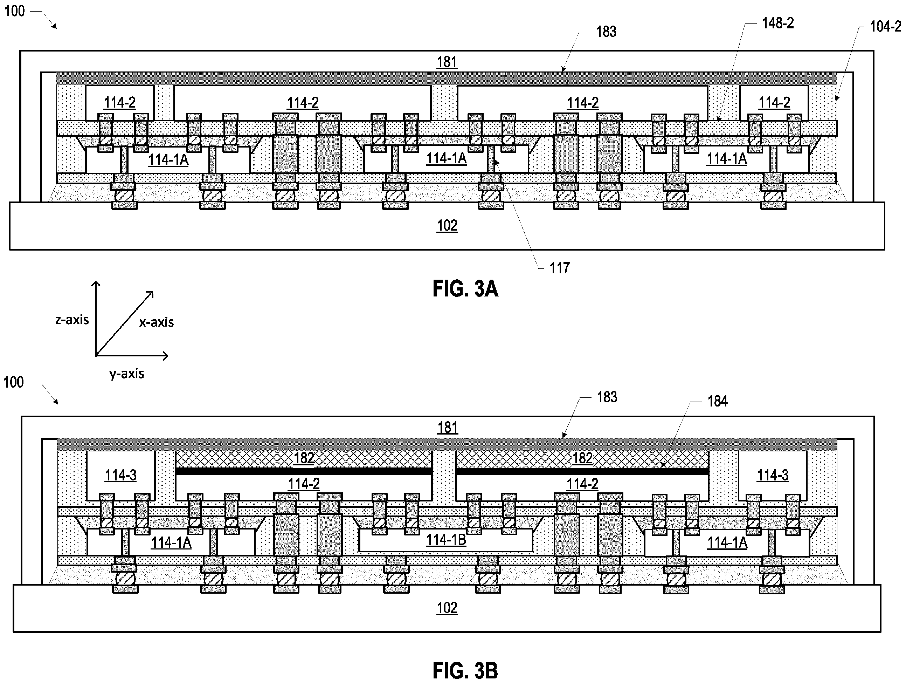

FIGS. 2A-2F are top views of example microelectronic assemblies, in accordance with various embodiments. A microelectronic assembly 100 may have any suitable dimensions, any suitable number of layers, any suitable number of dies, and any suitable die arrangement. A package substrate 102 may have a surface area (e.g., xy-dimension, also referred to as "form factor") that is greater than 2,500 square millimeters (mm²) (e.g., 50 mm by 50 mm). In some embodiments, a package substrate 102 may have a surface area that is greater than 3,600 mm² (e.g., 60 mm by 60 mm). In some embodiments, a package substrate 102 may have a surface area that is greater than 10,000 mm² (e.g., 100 mm by 100 mm). In some embodiments, a package substrate 102 may have a surface area that is greater than 14,400 mm² (e.g., 120 mm by 120 mm). Typically, a reticle size is equal to 26 mm by 33 mm. An equivalent silicon content of second layer dies 114-2, 114-3 may be calculated with respect to the reticle size. For example, a total surface area of second layer dies 114-2, 114-3 divided by 858 mm² (e.g., 26 mm by 33 mm) is equal to an equivalent silicon content of the second layer dies 114-2, 114-3 with respect to a reticle size. In some embodiments, an equivalent silicon content of the second layer dies 114-2, 114-3 may be between 3.5 times and 6.5 times the reticle size. For example, an equivalent silicon content of the second layer dies 114-2, 114-3 may be between 3,003 mm² (e.g., 3.5 x 26 mm x 33 mm) and 5,577 mm² (e.g., 6.5 x 26 mm x 33 mm). An equivalent silicon content is based on a reticle size so the value may be even greater, such as between 6.5 times and 10 times, or even greater than 10 times. In some embodiments, a combined surface area of second layer dies 114-2, 114-3 (e.g., a sum of an xy-dimension of each second layer die 114-2, 114-3), or a combined surface area of second layer dies 114-2, as shown in FIG. 3A, is between 3,000 mm² and 9,000 mm². FIG. 2A illustrates a top view of a microelectronic assembly 100 including a first layer die 114-1A on and coupled to a package substrate 102 and second layer dies 114-2, 114-3 on and coupled to the first layer die 114-1A. The first layer dies 114-1A and the second layer dies 114-2, 114-3 are shown as repeating units on and coupled to the package substrate 102. The second layer dies 114-2 may be electrically coupled to the package substrate 102 by conductive pillars 152 (not shown). Although only two repeating units are shown in FIG. 2A, a microelectronic assembly 100 may have any suitable number of repeating units and may be based on a surface area (e.g., xy-dimension) of the package substrate 102. FIG. 2B illustrates a top view of a microelectronic assembly 100 including three first layer dies 114-1 (e.g., two first layer dies including TSVs 114-1A and a single first layer die 114-1B without TSVs 117), and four second layer dies 114-2, 114-3 (e.g., two of each of the second layer dies 114-2, 114-3) on a package substrate 102. FIG. 2C illustrates a top view of a microelectronic assembly 100 including repeating units of first layer dies 114-1 and second layer dies 114-2, 114-3, as shown in FIG. 2B. As shown in FIG. 2C, a microelectronic assembly 100 may include twelve (12) first layer dies 114-1, eight (8) second layer die 114-2, and eight (8) second layer die 114-3. FIG. 2D illustrates a top view of a microelectronic assembly 100 including nine (9) first layer dies 114-1, six (6) second layer dies 114-2, and twelve (12) second layer dies 114-3 on a package substrate 102, where two (2) second layer dies 114-3 are coupled to a first layer die 114-1. FIG. 2E illustrates a top view of a microelectronic assembly 100 including nineteen (19) first layer dies 114-1 (e.g., twelve (12) first layer dies 114-1A and seven (7) first layer dies 114-1B coupling the second layer dies 114-2), six (6) second layer dies 114-2, and twelve (12) second layer dies 114-3 on a package substrate 102, where individual second layer dies 114-3 are coupled to individual first layer die 114-1A. Although FIG. 2E illustrates first layer dies 114-1A and 114-1B, first layer dies 114-1 may include different arrangements and, in some embodiment, may include only first layer dies 114-1A. FIG. 2F illustrates a top view of a microelectronic assembly 100 including twenty (20) first layer dies 114-1A, one (1) second layer die 114-2, and twenty (20) second layer dies 114-3 on a package substrate 102, where individual second layer dies 114-3 are coupled to individual first layer die 114-1. Although FIG. 2F illustrates twenty (20) first layer dies 114-1 and twenty (20) second layer dies 114-3, a microelectronic assembly 100 may include less, for example, sixteen (16) first layer dies 114-1 and sixteen (16) second layer dies 114-3.

Many of the elements of the microelectronic assembly 100 of FIG. 1 are included in other ones of the accompanying drawings; the discussion of these elements is not repeated when discussing these drawings, and any of these elements may take any of the forms disclosed herein. Further, a number of elements are illustrated in FIG. 1 as included in the microelectronic assembly 100, but a number of these elements may not be present in a microelectronic assembly 100. For example, in various embodiments, the underfill material 127-2 and the package substrate 102 may not be included. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

FIG. 3A is a side, cross-sectional view of yet another example microelectronic assembly, in accordance with various embodiments. The embodiment shown in the figure is similar to that of FIG. 1, except that the first layer 104-1 includes only first layer dies 114-1A having TSVs 117, the second layer 104-2 includes only second layer dies 114-2 having a same thickness (e.g., z-height), the second layer dies 114-2 have conductive contacts on the bottom surface that are flush with the bottom surface, and the microelectronic assembly 100 further includes a thermal interface material (TIM) 183 and a heat spreader 181. The heat spreader 181 may be used to move heat away from the second layer dies 114-2, 114-3 (e.g., so that the heat may be more readily dissipated by a heat sink or other thermal management device). The heat spreader 181 may include any suitable thermally conductive material (e.g., metal, appropriate ceramics, etc.), and may include any suitable features (e.g., fins). In some embodiments, the heat spreader 181 may be an integrated heat spreader. In some embodiments, the heat spreader 181 may include an extended portion, or pedestal along the z-height, as shown, to provide physical contact with the TIM 183.

The microelectronic assembly 100 of FIG. 3A may also include a TIM 183 between the second layer dies 114-2, 114-3 and the heat spreader 181. The TIM 183 may include a thermally conductive material (e.g., metal particles) in a polymer or other binder. The TIM 183 may be a thermal interface material paste or a thermally conductive epoxy (which may be a fluid when applied and may harden upon curing, as known in the art). The TIM may include a solder TIM. The TIM 183 may provide a path for heat generated by the second layer dies 114-2, 114-3 to readily flow to the heat spreader 181, where it may be spread and/or dissipated.

FIG. 3B is a side, cross-sectional view of yet another example microelectronic assembly, in accordance with various embodiments. The embodiment shown in the figure is similar to that of FIG. 3A, except that the microelectronic assembly 100 further includes a spacer 182 between the second layer die 114-2 and the TIM 183. A spacer 182 may include any suitable material, for example, a metal, such as copper, aluminum, nickel, and metal alloys. In some embodiments, a spacer 182 may be physically attached to a top surface of the second layer dies 114-2 by an adhesive 184 or other similar material. A thickness (e.g., z-height) of the spacer 182 and the second layer dies 114-2 may be substantially equal to a thickness of the second layer die 114-3. For example, a second layer die 114-2 may include a CPU having a thickness of 370 microns and a second layer die 114-3 may include an HBM having a thickness of 750 microns, and the spacer 182 may have a thickness of 380 microns.

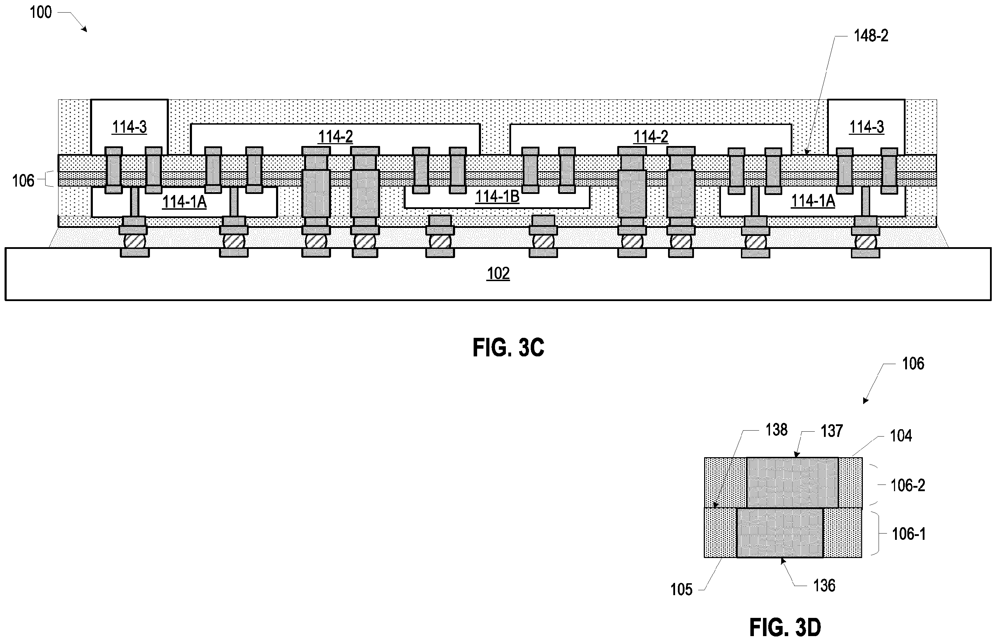

FIG. 3C is a side, cross-sectional view of yet another example microelectronic assembly, in accordance with various embodiments. The embodiment shown in the figure is similar to that of FIG. 3A, except that the microelectronic assembly 100 includes hybrid bond interconnects 106 to electrically couple the first layer die 114-1 and the second layer die 114-2, 114-3. FIG. 3D is a schematic cross-sectional view of a detail of a particular one of interconnects 106 in microelectronic assembly 100. An example of interconnect 106 in some embodiments is a hybrid bond comprising metal-metal bonds and dielectric-dielectric bonds. In a general sense, interconnect 106 may include, at an interface 138 between layers 106-1 and 106-2, metal-metal bonds, between bond-pad 136 of layer 106-1 and bond-pad 137 of layer 106-2, and dielectric-dielectric bonds in layers 106-1 and 106-2. Bond-pad 136 of layer 106-1 may bond with bond-pad 137 of layer 106-2. Bond pads 136, 137 also may be referred to herein as conductive contacts or metal contacts. A material of the metal-metal bonds (e.g., bond pads 136, 137) may include copper-copper. Dielectric material 105 in layers 106-1 and 106-2 may bond with each other. The dielectric material 105 may include an inorganic dielectric (e.g., silicon and oxygen in the form of silicon oxide) or an organic dielectric (e.g., polyimide). The bonded metal and dielectric materials form interconnect 106, comprising hybrid bonds, providing electrical and mechanical coupling between layers 106-1 and 106-2. In some embodiments, interconnects 106 may have a pitch between 1 micron and 75 microns.

### Example methods

Any suitable techniques may be used to manufacture the microelectronic assemblies 100 disclosed herein. For example, FIGS. 4A-4I are side, cross-sectional views of various stages in an example process for manufacturing the microelectronic assembly 100 of FIG. 1, in accordance with various embodiments. Although the operations discussed below with reference to FIGS. 4A-4I (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 4A-4I may be modified in accordance with the present disclosure to fabricate others of microelectronic assembly 100 disclosed herein.

FIG. 4A illustrates an assembly subsequent to mounting second layer dies 114-2, 114-3 on a first carrier 401-1 with conductive contacts facing towards the first carrier 401-1. Any suitable method may be used to place the second layer dies 114-2, 114-3 for example, automated pick-and-place. A carrier 401 may include any suitable material for providing mechanical stability during manufacturing operations, and in some embodiments, may include a semiconductor wafer (e.g., a silicon wafer) or glass (e.g., a glass panel). The second layer dies 114-2, 114-3 may be attached to the first carrier 401-1 using any suitable technique, such as a removable adhesive 403.

FIG. 4B illustrates an assembly subsequent to depositing a second insulating material 133-2 on and around the second layer dies 114-2, 114-3 and planarizing a top surface of the second insulating material 133-2. The second insulating material 133-2 may be formed using any suitable process, including a molding process. In some embodiments, the second insulating material 133-2 may be dispensed in liquid form to flow around and conform to various shapes of components and metallization, and, subsequently, may be subjected to a process, for example, curing, that solidifies the second insulating material 133-2. The second insulating material 133-2 may be removed (e.g., planarized) using any suitable technique, including grinding or chemical mechanical polishing (CMP).

FIG. 4C illustrates an assembly subsequent to attaching a second carrier 401-2 to a top surface of the assembly of FIG. 4B. The second carrier 401-2 may include any suitable carrier, as described above with reference to FIG. 4A, and may be attached using any suitable technique, such as a removable adhesive 403.

FIG. 4D illustrates an assembly subsequent to removing the first carrier 401-1, inverting the assembly, forming a second RDL 148-2 with conductive pathways 196, and conductive pillars 152 on a top surface of the assembly. The second RDL 148-2 may be manufactured using any suitable technique, such as a PCB technique or a redistribution layer technique. The conductive pillars 152 may be formed using any suitable technique, for example, a lithographic process or an additive process, such as cold spray or 3-dimensional printing.

FIG. 4E illustrates an assembly subsequent to placing first layer die 114-1 on a top surface of the assembly of FIG. 4D, forming interconnects 120 between the first layer die 114-1 and the second layer dies 114-2, 114-3, and depositing an underfill material 127-1 around the interconnects 120. Any suitable method may be used to place the first layer die 114-1, for example, automated pick-and-place. The assembly of FIG. 4E may be subjected to a solder reflow process.

FIG. 4F illustrates an assembly subsequent to depositing a first insulating material 133-1 on and around the first layer dies 114-1 and the conductive pillars 152, and planarizing a top surface of the first insulating material 133-1. The first insulating material 133-1 may be formed and planarized using any suitable processes, including as described above with reference to FIG. 4B.

FIG. 4G illustrates an assembly subsequent to forming a first RDL 148-1 with conductive pathways 196 and conductive contacts 174 on a top surface of the assembly of FIG. 4F. The first RDL 148-1 may be manufactured using any suitable technique, as described above with reference to FIG. 4D.

FIG. 4H illustrates an assembly subsequent to depositing solder 134 on conductive contacts 174. In some embodiments other finishing operations may be performed. Example finishing operations include depositing solder resist (not shown).

FIG. 4I illustrates an assembly subsequent to removing the second carrier 401-2 and inverting the assembly. If multiple assemblies are manufactured together, the assemblies may be singulated after removal of the second carrier 401-2. The assembly of FIG. 4I may itself be a microelectronic assembly 100, as shown. Further manufacturing operations may be performed on the microelectronic assembly 100 of FIG. 4I to form other microelectronic assembly 100; for example, the solder 134 may be used to couple the microelectronic assembly 100 of FIG. 4I to a package substrate 102 via interconnects 130, similar to the microelectronic assembly 100 of FIG. 1, and attaching a TIM 183 and a heat spreader 181, similar to the microelectronic assembly of FIG. 3A.

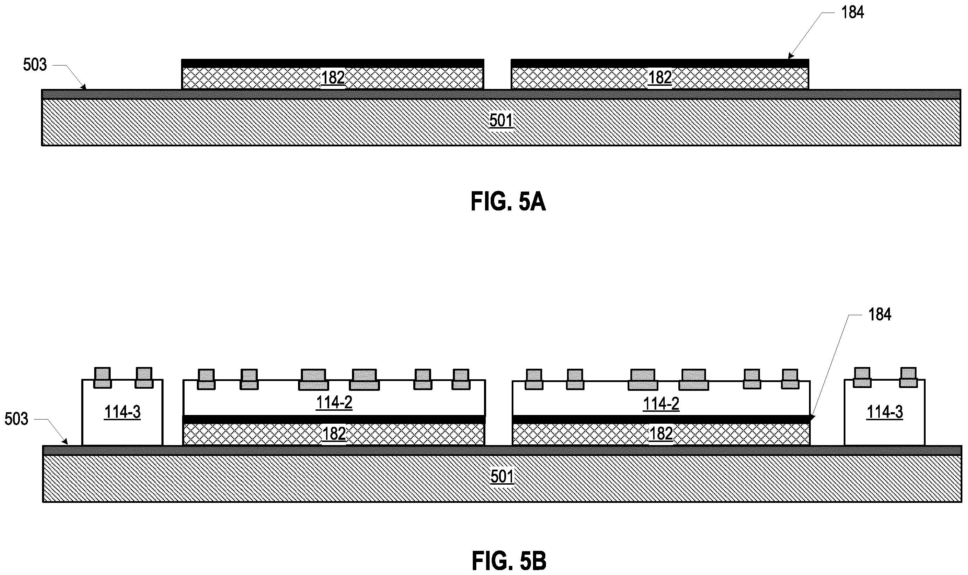

FIGS. 5A-5H are side, cross-sectional views of various stages in an example process for manufacturing the microelectronic assembly 100 of FIG. 3B, in accordance with various embodiments. FIG. 5A illustrates an assembly subsequent to mounting a spacer 182 on a carrier 501. A carrier 501 may include any suitable material for providing mechanical stability during manufacturing operations, and in some embodiments, may include a semiconductor wafer (e.g., a silicon wafer) or glass (e.g., a glass panel). The spacers 182 may be attached to the carrier 501 using any suitable technique, such as a removable adhesive 503. In some embodiments, an adhesive 184 may be on, or may be deposited on, a top surface of the spacer 182.

FIG. 5B illustrates an assembly subsequent to mounting second layer dies 114-2, 114-3 on the carrier 501 with conductive contacts facing away from the carrier 501. The second layer die 114-2 may be attached to the adhesive 184 on a top surface of the spacer 182 and the second layer die 114-3 may be attached to the adhesive 503 on a top surface of the carrier 501. Any suitable method may be used to place the second layer dies 114-2, 114-3 for example, automated pick-and-place.

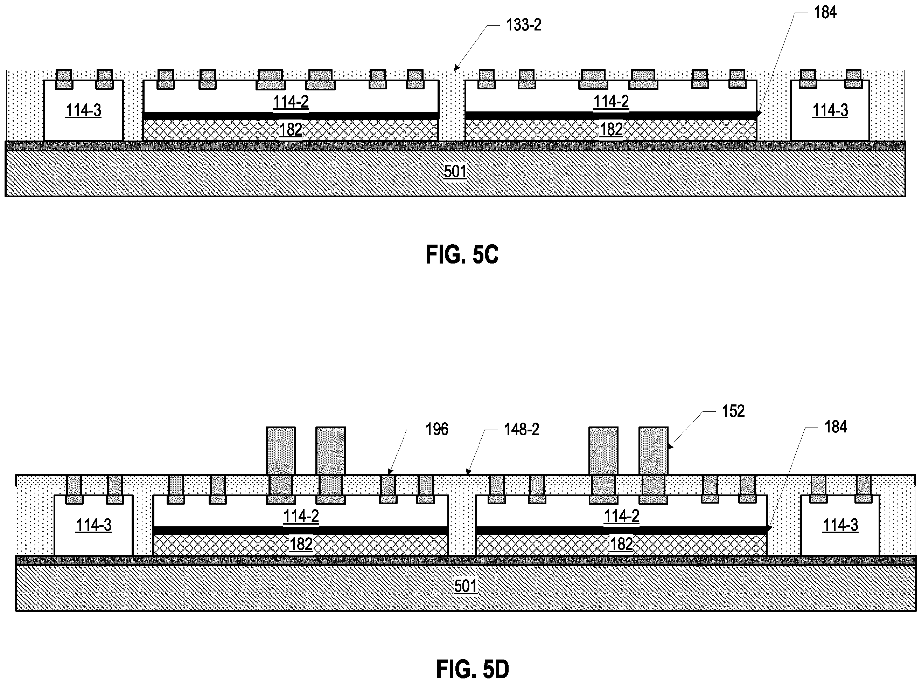

FIG. 5C illustrates an assembly subsequent to depositing a second insulating material 133-2 on and around the spacers 182 and the second layer dies 114-2, 114-3, and planarizing a top surface of the second insulating material 133-2. The second insulating material 133-2 may be formed using any suitable process, including a molding process. In some embodiments, the second insulating material 133-2 may be dispensed in liquid form to flow around and conform to various shapes of components and metallization, and, subsequently, may be subjected to a process, for example, curing, that solidifies the second insulating material 133-2. The second insulating material 133-2 may be removed (e.g., planarized) using any suitable technique, including grinding or CMP.

FIG. 5D illustrates an assembly subsequent to forming a second RDL 148-2 with conductive pathways 196, and conductive pillars 152 on a top surface of the assembly of FIG. 5C. The second RDL 148-2 may be manufactured using any suitable technique, such as a PCB technique or a redistribution layer technique. The conductive pillars 152 may be formed using any suitable technique, for example, a lithographic process or an additive process, such as cold spray or 3-dimensional printing.

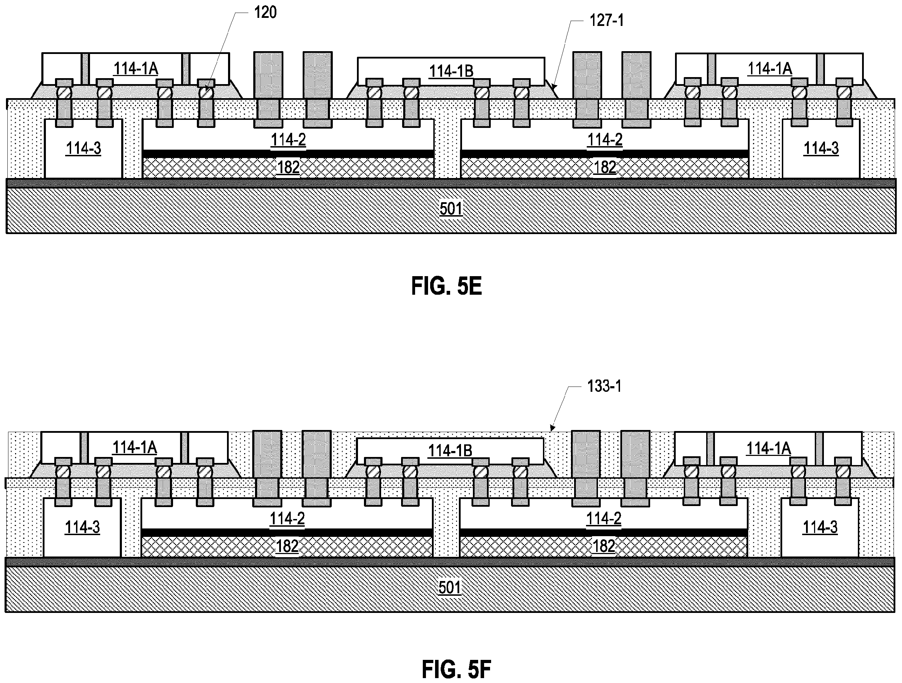

FIG. 5E illustrates an assembly subsequent to placing first layer die 114-1 on a top surface of the assembly of FIG. 5D, forming interconnects 120 between the first layer die 114-1 and the second layer dies 114-2, 114-3, and depositing an underfill material 127-1 around the interconnects 120. Any suitable method may be used to place the first layer die 114-1, for example, automated pick-and-place. The assembly of FIG. 5E may be subjected to a solder reflow process.

FIG. 5F illustrates an assembly subsequent to depositing a first insulating material 133-1 on and around the first layer dies 114-1 and the conductive pillars 152, and planarizing a top surface of the first insulating material 133-1. The first insulating material 133-1 may be formed and planarized using any suitable processes, including as described above with reference to FIG. 5C.

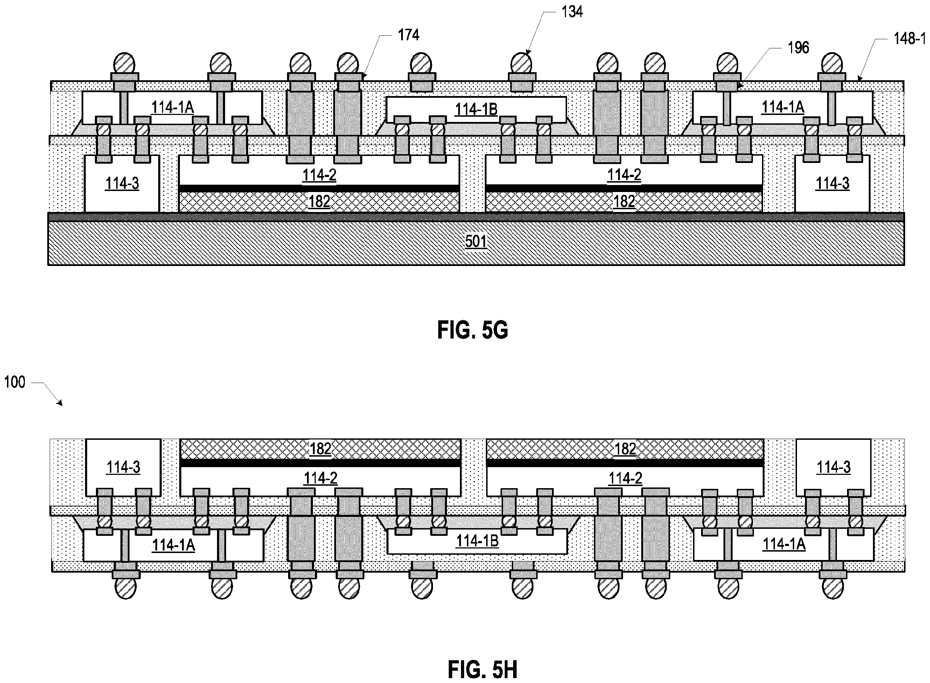

FIG. 5G illustrates an assembly subsequent to forming a first RDL 148-1 with conductive pathways 196 and conductive contacts 174 on a top surface of the assembly of FIG. 5F, performing finishing operations, and depositing solder 134 on conductive contacts 174. The first RDL 148-1 may be manufactured using any suitable technique, as described above with reference to FIG. 5D. Example finishing operations include depositing solder resist (not shown).

FIG. 5H illustrates an assembly subsequent to removing the carrier 501 and inverting the assembly. If multiple assemblies are manufactured together, the assemblies may be singulated after removal of the carrier 501. The assembly of FIG. 5H may itself be a microelectronic assembly 100, as shown. Further manufacturing operations may be performed on the microelectronic assembly 100 of FIG. 5H to form other microelectronic assembly 100; for example, the solder 134 may be used to couple the microelectronic assembly 100 of FIG. 5H to a package substrate 102 via interconnects 130, and attaching a TIM 183 and a heat spreader 181, similar to the microelectronic assembly of FIG. 3B.

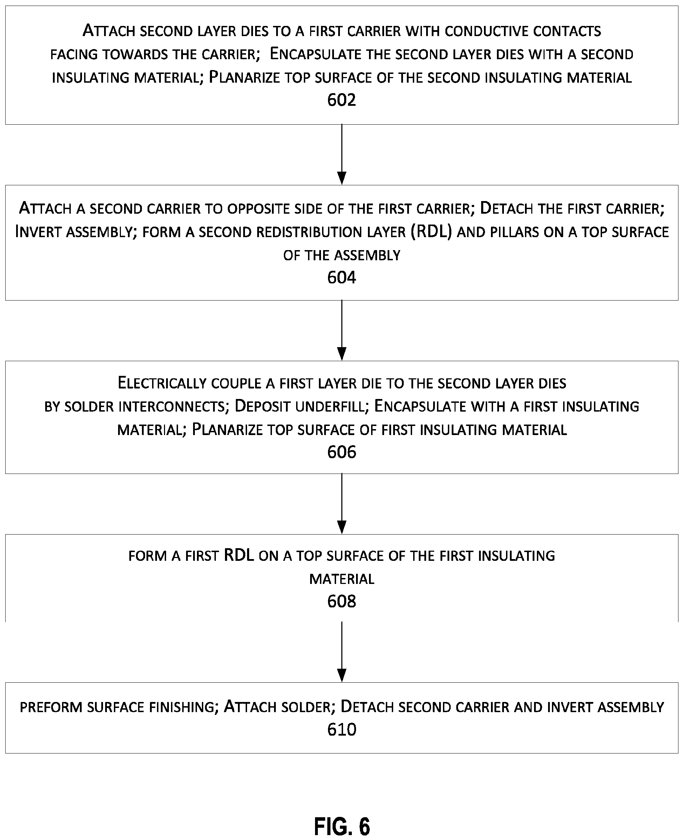

FIG. 6 is a flow diagram of an example method of fabricating an example microelectronic assembly, in accordance with various embodiments. At 602, second layer dies 114-2, 114-3 may be attached to a first carrier (e.g., first carrier 401-1 in FIG. 4) with conductive contacts facing towards the first carrier, the second layer dies 114-2, 114-3 may be encapsulated with a second insulating material 133-2, and the top surface of the second insulating material 133-2 may be planarized. At 604, a second carrier (e.g., second carrier 401-2 in FIG. 4) may be attached opposite the first carrier, the first carrier may be removed, the assembly may be inverted, and a second RDL 148-2 and conductive pillars 152 may be formed on the top surface of the assembly. At 606, first layer dies 114-1 may be electrically coupled to the second layer dies 114-2, 114-3 by interconnects 120, an underfill material 127-1 may be deposited around the interconnects 120, and a first insulating material 133-1 may be deposited on and around the first layer dies 114-1 and planarized. At 608, a first RDL 148-1 with conductive pathways 196 may be formed on the first insulating material 133-1. At 610, finishing operations may be performed, including depositing solder resist and attaching solder 134 to conductive contacts 174, the second carrier may be removed, and the assembly may be inverted.

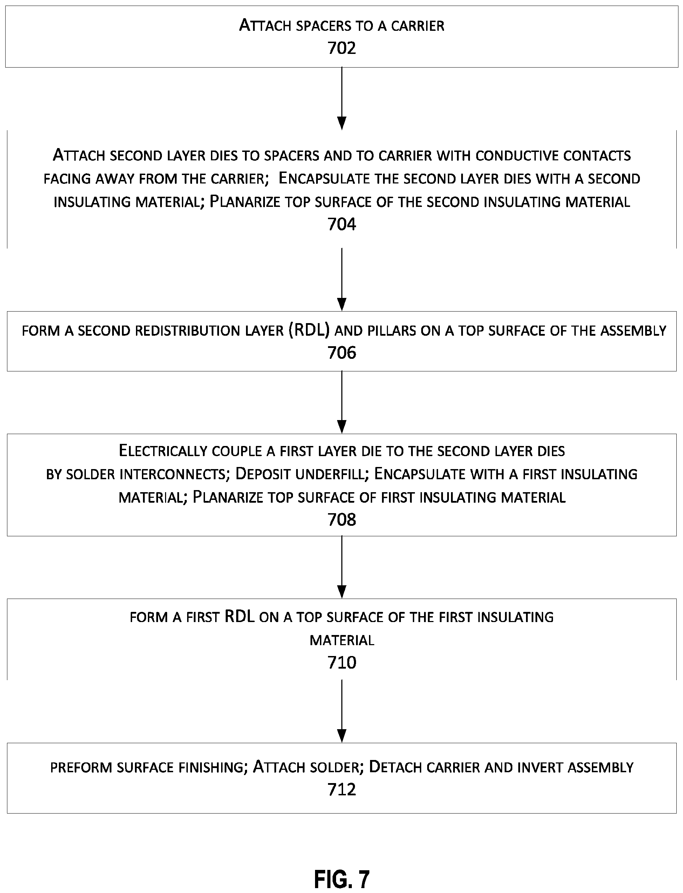

FIG. 7 is a flow diagram of an example method of fabricating an example microelectronic assembly, in accordance with various embodiments. At 702, spacers 182 may be attached to a carrier (e.g., the carrier 501 in FIG. 5). The spacers 182 may include an adhesive 184 on a top surface or an adhesive may be deposited on a top surface of the spacers. At 704, second layer dies 114-2, 114-3 may be attached to the carrier with conductive contacts facing away from the carrier, the second layer dies 114-2, 114-3 may be encapsulated with a second insulating material 133-2, and the top surface of the second insulating material 133-2 may be planarized. The second layer dies 114-2 may be attached to a top surface of the spacers 182 and the second layer dies 114-3 may be attached to a top surface of the carrier. At 706, a second RDL 148-2 and conductive pillars 152 may be formed on the top surface of the assembly. At 708, first layer dies 114-1 may be electrically coupled to the second layer dies 114-2, 114-3 by interconnects 120, an underfill material 127-1 may be deposited around the interconnects 120, and a first insulating material 133-1 may be deposited on and around the first layer dies 114-1 and planarized. At 710, a first RDL 148-1 with conductive pathways 196 may be formed on the first insulating material 133-1. At 712, finishing operations may be performed, including depositing solder resist and attaching solder 134 to conductive contacts 174, the carrier may be removed, and the assembly may be inverted.

### Example devices and components

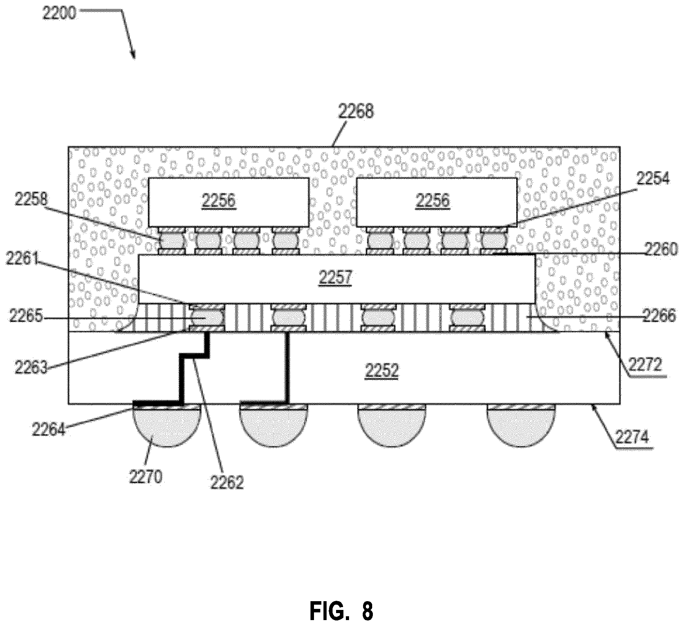

The packages disclosed herein, e.g., any of the embodiments shown in FIGS. 1-3 or any further embodiments described herein, may be included in any suitable electronic component. FIGS. 8-10 illustrate various examples of packages, assemblies, and devices that may be used with or include any of the IC packages as disclosed herein.

FIG. 8 is a side, cross-sectional view of an example IC package 2200 that may include IC packages in accordance with any of the embodiments disclosed herein. In some embodiments, the IC package 2200 may be a SiP.

As shown in the figure, package substrate 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures including lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

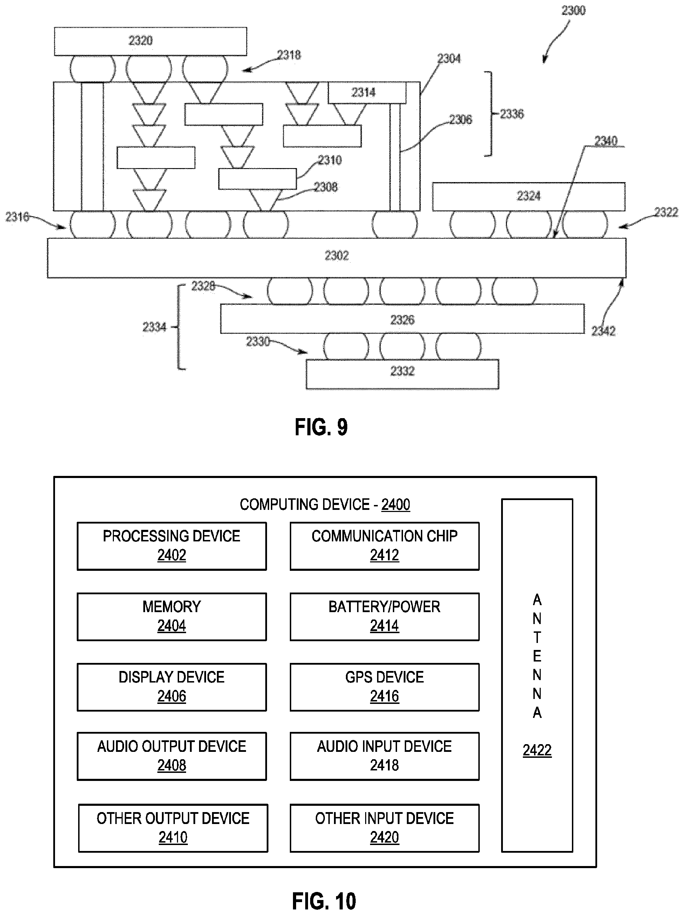

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (e.g., for a ball grid array (BGA) arrangement), but any suitable second-level interconnects 2270 may be used (e.g., pins in a pin grid array arrangement or lands in a land grid array arrangement). Second-level interconnects 2270 may be used to couple IC package 2200 to another component, such as a circuit board (e.g., a motherboard), an interposer, or another IC package, as known in the art and as discussed below with reference to FIG. 9.

In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 100 as described herein, one or more of dies 2256 may be logic dies (e.g., silicon-based dies), one or more of dies 2256 may be memory dies (e.g., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 9 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 8.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, e.g., as described above with reference to FIG. 8.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 10 is a block diagram of an example computing device 2400 that may include one or more components having one or more IC packages in accordance with any of the embodiments disclosed herein. For example, any suitable ones of the components of computing device 2400 may include a microelectronic assembly 100 in accordance with any of the embodiments disclosed herein. In another example, any one or more of the components of computing device 2400 may include any embodiments of IC package 2200 (e.g., as shown in FIG. 8). In yet another example, any one or more of the components of computing device 2400 may include an IC device assembly 2300 (e.g., as shown in FIG. 9).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single system-on-chip (SOC) die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), LTE project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

### Select examples

The descriptions of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 is a microelectronic assembly, including a first layer including first dies in a first insulating material; a second layer on the first layer, the second layer including second dies having a first thickness and third dies having a second thickness different than the first thickness, wherein the second dies and the third dies are in a second insulating material, wherein the second dies and the third dies have a first surface and an opposing second surface, wherein the first surfaces of the second and third dies have a combined surface area between 3,000 square millimeters (mm²) and 9,000 mm²; and a redistribution layer (RDL) between the first layer and the second layer, the RDL including conductive pathways through the RDL, wherein the first dies are electrically coupled to the second and third dies by the conductive pathways through the RDL and by interconnects.

Example 2 may include the subject matter of Example 1, and may further specify that the interconnects include solder.

Example 3 may include the subject matter of Example 2, and may further include an underfill material between the second surfaces of the first dies and the RDL and surrounding the interconnects, wherein the underfill material has an inverted trapezoidal shape.

Example 4 may include the subject matter of Example 1, and may further specify that the interconnects include metal-metal bonds and dielectric-dielectric bonds.

Example 5 may include the subject matter of any of Examples 1-4, and may further specify that a pitch of the interconnects is between 1 micron and 75 microns.

Example 6 may include the subject matter of any of Examples 1-5, and may further specify that some of the first dies further include through-silicon vias (TSVs).

Example 7 may include the subject matter of any of Examples 1-6, and may further specify that the first layer further includes conductive pillars through the first insulating material and electrically coupled to the second dies.

Example 8 may include the subject matter of any of Examples 1-7, and may further specify that the first insulating material or the second insulating material includes conductive particles in a mold material, a resin material, or an epoxy material.

Example 9 may include the subject matter of Example 8, and may further specify that the conductive particles include silver and oxygen, aluminum and oxygen, or combinations thereof.

Example 10 may include the subject matter of any of Examples 1-9, and may further specify that the first dies include a bridge die.

Example 11 may include the subject matter of any of Examples 1-10, and may further specify that the second dies include a central processing unit (CPU), a graphics processing unit (GPU), an input/output (I/O) tile, or a system-on-chip (SOC) die, and the third dies include a high bandwidth memory (HBM) die.

Example 12 may include the subject matter of any of Examples 1-11, and may further include a spacer on the second dies in the second layer.

Example 13 may include the subject matter of Example 12, and may further specify that a material of the spacer includes one or more of copper, aluminum, nickel, or a metal alloy.

Example 14 may include the subject matter of any of Examples 1-13, and may further specify that the RDL is a second RDL including second conductive pathways, and the microelectronic assembly may further include a first RDL including first conductive pathways, wherein the first layer is on the first RDL.

Example 15 may include the subject matter of Example 14, and may further include a package substrate electrically coupled to the first RDL.

Example 16 may include the subject matter of Example 15, and may further specify that a surface area of the package substrate is between 2,500 square millimeters (mm²) and 14,400 mm².

Example 17 may include the subject matter of Example 15, and may further specify that a surface area of the package substrate is greater than 2,500 square millimeters.

Example 18 may include the subject matter of Example 15, and may further include a heat spreader on the second layer.

Example 19 may include the subject matter of Example 18, and may further include a thermal interface material (TIM) between the heat spreader and the second layer.

Example 20 is a microelectronic assembly, including first dies surrounded by a first insulating material; a redistribution layer (RDL), on the first dies, including conductive pathways through the RDL; and second dies, on the RDL, surrounded by a second insulating material, the second dies having a first surface and an opposing second surface, wherein the first surfaces of the second dies have a combined surface area between 3,000 square millimeters (mm²) and 9,000 mm², and may further specify that the first dies are electrically coupled to the second dies by interconnects including solder, and wherein the interconnects are surrounded by an underfill material having an inverted trapezoidal shape.

Example 21 may include the subject matter of Example 20, and may further specify that a pitch of the interconnects is between 25 micron and 75 microns.

Example 22 may include the subject matter of Examples 20 or 21, and may further specify that some of the first dies further include through-silicon vias (TSVs).

Example 23 may include the subject matter of any of Examples 20-22, and may further include conductive pillars through the first insulating material and electrically coupled to some of the second dies.

Example 24 may include the subject matter of any of Examples 20-23, and may further specify that the first insulating material or the second insulating material includes conductive particles in a mold material, a resin material, or an epoxy material.

Example 25 may include the subject matter of Example 24, and may further specify that the conductive particles include silver and oxygen, aluminum and oxygen, or combinations thereof.

Example 26 may include the subject matter of any of Examples 20-25, and may further specify that the first dies include a bridge die.

Example 27 may include the subject matter of any of Examples 20-26, and may further specify that some of the second dies include a central processing unit (CPU), a graphics processing unit (GPU), an input/output (I/O) tile, or a system-on-chip (SOC) die and some of the second dies include high bandwidth memory dies.

Example 28 may include the subject matter of any of Examples 20-26, and may further specify that some of the second dies have a first thickness and some of the second dies have a second thickness greater than the first thickness.

Example 29 may include the subject matter of Example 28, and may further include a spacer on the some of the second dies having the first thickness and surrounded by the second insulating material.

Example 30 may include the subject matter of any of Examples 20-29, and may further specify that the first dies include a third surface and an opposing fourth surface, wherein the RDL is a second RDL including second conductive pathways at the fourth surface of the first dies, and the microelectronic assembly may further include a first RDL including first conductive pathways at the third surface of the first dies, and a package substrate electrically coupled to the first conductive pathways in the first RDL, wherein a surface area of the package substrate is between 2,500 square millimeters (mm²) and 14,400 mm².

Example 31 may include the subject matter of Example 30, and may further include a heat spreader on the second insulating material surrounding the second dies.

Example 32 may include the subject matter of Example 31, and may further include a thermal interface material (TIM) between the heat spreader and the second insulating material.

Example 33 is a microelectronic assembly, including a first redistribution layer (RDL) including first conductive pathways; a first layer on the first RDL, the first layer including first dies in a first insulating material; a second RDL on the first layer, the second RDL including second conductive pathways; and a second layer on the second RDL, the second layer including second dies having a first thickness and third dies having a second thickness different than the first thickness, wherein the second dies and the third dies are in a second insulating material, wherein the second and third dies have a first surface and an opposing second surface and the first surfaces of the second and third dies have a combined surface area between 3,000 square millimeters (mm²) and 9,000 mm², and wherein the first dies are electrically coupled to the second and third dies by the second conductive pathways through the second RDL and by interconnects.

Example 34 may include the subject matter of Example 33, and may further specify that the interconnects include solder.

Example 35 may include the subject matter of Example 34, and may further specify that the first dies include a third surface and an opposing fourth surface, and the microelectronic assembly may further include an underfill material between the fourth surfaces of the first dies and the second RDL and surrounding the interconnects, wherein the underfill material has an inverted trapezoidal shape.

Example 36 may include the subject matter of Example 33, and may further specify that the interconnects include metal-metal bonds and dielectric-dielectric bonds.

Example 37 may include the subject matter of any of Examples 33-36, and may further specify that a pitch of the interconnects is between 1 micron and 75 microns.

Example 38 may include the subject matter of any of Examples 33-37, and may further specify that the first layer further includes conductive pillars through the first insulating material and electrically coupled to the second dies by the second conductive pathways.

Example 39 may include the subject matter of any of Examples 33-38, and may further specify that the first insulating material or the second insulating material includes conductive particles in a mold material, a resin material, or an epoxy material.

Example 40 may include the subject matter of Example 39, and may further specify that the conductive particles include silver and oxygen, aluminum and oxygen, or combinations thereof.

Example 41 may include the subject matter of any of Examples 33-40, and may further specify that the first dies include a bridge die.

Example 42 may include the subject matter of any of Examples 33-41, and may further specify that the second dies include a central processing unit (CPU), a graphics processing unit (GPU), an input/output (I/O) tile, or a system-on-chip (SOC) die, and the third dies include a high bandwidth memory (HBM) die.

Example 43 may include the subject matter of any of Examples 33-42, and may further specify that an equivalent silicon content of the second dies and the third dies is greater than 3,000 square millimeters (mm²).

Example 44 may include the subject matter of any of Examples 33-42, and may further specify that an equivalent silicon content of the second dies and the third dies is greater than 5,500 square millimeters (mm²).

Example 45 may include the subject matter of any of Examples 33-44, and may further include a spacer on the second dies in the second layer.

Example 46 may include the subject matter of any of Examples 33-45, and may further include a package substrate electrically coupled to the first conductive pathways in the first RDL, wherein a surface area of the package substrate is between 2,500 square millimeters (mm²) and 14,400 mm².

Example 47 may include the subject matter of Example 46, and may further include a heat spreader on the second layer.

Example 48 may include the subject matter of Example 47, and may further include a thermal interface material (TIM) between the heat spreader and the second layer.

## Claims

1. A microelectronic assembly, comprising:
a first layer including first dies in a first insulating material;
a second layer on the first layer, the second layer including second dies having a first thickness and third dies having a second thickness different than the first thickness, wherein the second dies and the third dies are in a second insulating material, wherein the second dies and third dies have a first surface and an opposing second surface, and wherein the first surfaces of the second and third dies have a combined surface area between 3,000 square millimeters (mm²) and 9,000 mm²; and
a redistribution layer (RDL) between the first layer and the second layer, the RDL including conductive pathways through the RDL, wherein the first dies are electrically coupled to the second dies and the third dies by the conductive pathways through the RDL and by interconnects.

2. The microelectronic assembly of claim 1, wherein the interconnects include solder, and the microelectronic assembly further comprising:
an underfill material between the second surfaces of the first dies and the RDL and surrounding the interconnects, wherein the underfill material has an inverted trapezoidal shape.

3. The microelectronic assembly of claim 1 or 2, wherein the interconnects include metal-metal bonds and dielectric-dielectric bonds.

4. The microelectronic assembly of claim 1, 2 or 3, wherein a pitch of the interconnects is between 1 micron and 75 microns.

5. The microelectronic assembly of any one of claims 1-4, wherein the first layer further includes conductive pillars through the first insulating material and electrically coupled to the second dies.

6. The microelectronic assembly of any one of claims 1-5, wherein the first insulating material or the second insulating material includes conductive particles in a mold material, a resin material, or an epoxy material.

7. The microelectronic assembly of claim 6, wherein the conductive particles include silver and oxygen, aluminum and oxygen, or combinations thereof.

8. The microelectronic assembly of any one of claims 1-7, wherein the first dies include a bridge die, and wherein the second dies include a central processing unit (CPU), a graphics processing unit (GPU), an input/output (I/O) tile, or a system-on-chip (SOC) die, and the third dies include a high bandwidth memory (HBM) die.

9. The microelectronic assembly of any one of claims 1-8, further comprising:
a spacer on the second dies in the second layer.

10. The microelectronic assembly of claim 9, wherein a material of the spacer includes one or more of copper, aluminum, nickel, or a metal alloy.

11. The microelectronic assembly of any one of claims 1-10, wherein the RDL is a second RDL including second conductive pathways, and the microelectronic assembly further comprising:
a first RDL including first conductive pathways, wherein the first layer is on the first RDL.

12. The microelectronic assembly of claim 11, further comprising:
a package substrate electrically coupled to the first conductive pathways in first RDL, wherein a surface area of the package substrate is between 2,500 square millimeters (mm²) and 14,400 mm².

13. The microelectronic assembly of any one of claims 1-12, wherein some of the first dies further include through-silicon vias (TSVs).

14. The microelectronic assembly of any one of claims 1-13, further comprising:
a heat spreader on the second layer.

15. The microelectronic assembly of claim 14, further comprising:
a thermal interface material (TIM) between the heat spreader and the second layer.
